# EUROPÄISCHE PATENTSCHRIFT

(11) **EP 0 842 546 B1**
(45) Veröffentlichungstag und Bekanntmachung des Hinweises auf die Patenterteilung: **16.06.1999**
(21) Anmeldenummer: 96926399.5
(22) Anmeldetag: 26.07.1996
(51) Int. Cl.: H01L 39/24

(54) **SUPRALEITERVORMISCHUNG**
SUPERCONDUCTOR MIXTURE
PREMELANGE SUPRACONDUCTEUR

(30) Priorität: 04.08.1995 DE 19528799; 02.02.1996 DE 19603820
(43) Veröffentlichungstag der Anmeldung: 20.05.1998
(73) Patentinhaber: SOLVAY BARIUM STRONTIUM GmbH, D-30173 Hannover (DE); INSTITUT FÜR PHYSIKALISCHE HOCHTECHNOLOGIE E.V., 07702 Jena (DE)
(72) Erfinder: PARK, Jai, Won, D-37085 Göttingen (DE); KÖHLER, Karl, D-31199 Diekholzen (DE); HARDINGHAUS, Ferdinand, D-53557 Bad Hönningen (DE); JÄGER, Paul, D-30459 Hannover (DE); FISCHER, Klaus, D-07751 Jena-Cospeda (DE); HABISREUTHER, Tobias, D-07743 Jena (DE); GAWALEK, Wolfgang, D-07749 Jena (DE); LITZKENDORF, Doris, D-07751 Jena-Cospeda (DE); GÖRNERT, Peter, D-07747 Jena (DE); WU, Minzhi, D-07745 Jena (DE)
(74) Vertreter: Lauer, Dieter, Dr.
(86) Internationale Anmeldenummer: EP9603312
(87) Internationale Veröffentlichungsnummer: WO9706567

(56) Entgegenhaltungen:
- EP-A- 0 284 438
- EP-A- 0 575 968
- WO-A-90/04568
- US-A- 5 413 981
- 1994 APPLIED SUPERCONDUCTIVITY CONFERENCE, BOSTON, MA, USA, 16-21 OCT. 1994, Bd. 5, Nr. 2, pt.2, ISSN 1051-8223, IEEE TRANSACTIONS ON APPLIED SUPERCONDUCTIVITY, JUNE 1995, USA, Seiten 1623-1626, XP002017968 TODT V R ET AL: "Melt-processing of YBa/sub 2/Cu/sub 3/O/sub x/ and Bi/sub 2/Sr/sub 2/CaCu/sub 2/O/sub y/: influence of processing parameters on microstructure and magnetization behavior"
- APPLIED PHYSICS A. SOLIDS AND SURFACES, Bd. A49, Nr. 2, August 1989, Seiten 139-141, XP000038511 BALIGA S ET AL: "ENHANCED GRAIN GROWTH IN YBA2CU3O7- DOPED WITH AG, CU, AND CUO"

## Beschreibung

Die Erfindung betrifft eine für die Schmelzprozessierung hergerichtete Supraleitervormischung, ein entsprechendes Herstellverfahren und ein für die Herstellung der Vormischung verwendbares YBa₂Cu₃O₇₋ₓ-Pulver.

YBa₂Cu₃O₇₋ₓ-Pulver (x = 0 bis 0,5) wird für die Herstellung technischer Supraleiter verwendet. Man vermischt das Pulver vorteilhaft mit stabilisierenden bzw. Haft- oder Pinningzentren bildenden Zusätzen. Die dabei erhaltene Vormischung wird zu Formkörpern verpreßt und temperaturbehandelt, vorteilhaft durch Schmelzprozessieren. Beim Schmelzprozessieren werden die Oberflächen der Pulverpartikel der Vormischung angeschmolzen, so daß die Partikel beim anschließenden Abkühlen fest miteinander verbunden werden. Der Fluß des elektrischen Stromes über die Korngrenzen hinweg wird dadurch verbessert. Die stabilisierenden Zusätze wirken üblicherweise derart, daß u. a. die Schmelztemperatur der Vormischung herabgesetzt wird, so daß das bei anderenfalls höheren Schmelztexturierungstemperaturen beobachtete Erweichen der zu bildenden Formkörper bzw. ein Auslaufen von flüssigem Material verhindert werden kann. Die Zusätze, welche Haft- bzw. Pinningzentren bilden, ermöglichen eine Erhöhung der kritischen Stromdichte in den Supraleitern. Die Pinningzentren sorgen für eine Verankerung der magnetischen Flußlinien, so daß auch im Magnetfeld hohe kritische Ströme erreicht werden können. Flux-Pinning-Zusätze für Supraleiter auf Kupferoxid-Basis werden beispielsweise in den europäischen Patentanmeldungen EP-A-0 292 126 und 296 380 offenbart.

Die Veröffentlichung V.R. Todt et al., IEEE Transactions on Applied Superconductivity, Vol 5, No 2 (1995) S. 1623-26, befaßt sich mit dem Schmelzprozessieren von 1-2-3-Supraleitermaterial. Während Kohlenstoff während des Schmelzprozessierens vorteilhaft bezüglich des Flux-Pinning-Verhaltens wirkt, hat er einen negativen Effekt auf die Korngrenzen. An der EP-A-0 284 438 wird eine Obergrenze von 0,1 Gew.-% Kohlenstoff-Gehalt als vorteilhaft für das Supraleitermaterial angesehen.

Die beim Schmelzprozessieren erhaltenen Formkörper aus Hochtemperatursupraleitermaterial können beispielsweise bei der Herstellung von Elektromotoren und bei der Herstellung des sogenannten "Fly Wheels" eingesetzt werden. Das Fly Wheel rotiert unter supraleitenden Bedingungen im Magnetfeld und dient zur Speicherung von kinetischer Energie.

Aufgabe der vorliegenden Erfindung ist es, eine verbesserte Vormischung auf Basis von YBa₂Cu₃O₇₋ₓ-Pulver mit stabilisierenden bzw. das Flux-Pinning bewirkenden Zusätzen zur Verfügung zu stellen. Diese Aufgabe wird durch die in den Ansprüchen angegebene Vormischung gelöst.

Die Erfindung beruht auf der Erkenntnis, daß Vormischungen, die YBa₂Cu₃O₇₋ₓ-Pulver und stabilisierende bzw. ein Flux-Pinning bewirkende Zusätze umfassen, dann besonders gut für die Herstellung schmelzprozessierter Formkörper geeignet sind, wenn sie einen geringen Gehalt an Kohlenstoff kombiniert mit einem geringen Gehalt an freiem nicht in der YBa₂Cu₃O₇₋ₓ-Phase gebundenes Kupferoxid aufweisen.

Die erfindungsgemäße, für die Schmelzprozessierung hergerichtete Supraleitervormischung umfaßt Zusätze, die ein "Flux Pinning" bewirken sowie YBa₂Cu₃O₇₋ₓ-Pulver, wobei dieses YBa₂Cu₃O₇₋ₓ-Pulver weniger als 0,6 Gew.-% freies, nicht in der YBa₂Cu₃O₇₋ₓ-Phase gebundenes Kupferoxid und, bezogen auf das YBa₂Cu₃O₇₋ₓ-Pulver, weniger als 0,1 Gew.-% Kohlenstoff enthält.

Die stabilisierenden bzw. das Flux Pinning bewirkenden Zusätze können prinzipiell in der gewünschten Menge zugesetzt werden, in der sie die gewünschte Wirkung zur Folge haben. Die stabilisierende Wirkung liegt z. B. darin, daß die Schmelztemperatur der Partikel in der Supraleitervormischung herabgesetzt wird. Die das Flux Pinning bewirkenden Zusätze bewirken, daß die magnetischen Flußlinien im Supraleitermaterial verankert werden und infolgedessen hohe kritische Ströme möglich werden. Man kann die üblichen, stabilisierend bzw. das Flux Pinning bewirkende Zusätze einsetzen. Es gibt Zusätze, z. B. Y₂BaCuO₅, von denen angenommen wird, daß sie sowohl stabilisierend als auch das Flux Pinning fördernd wirken. Besonders gut geeignet als Zusatz sind Y₂O₃, Y₂BaCuO₅, PtO₂, Ag₂O, CeO₂, SnO₂, ZrO₂, BaCeO₃ und BaTiO₃.

Bevorzugte erfindungsgemäße Supraleitervormischungen enthalten 0,1 bis 50 Gew.-% an stabilisierenden bzw. das Flux-Pinning bewirkenden Zusätzen, bezogen auf das als 100 Gew.-% gesetzte YBa₂Cu₃O₇₋ₓ-Pulver.

Bevorzugt ist ein Gehalt an Y₂O₃, Y₂BaCuO₅, PtO₂, Ag₂O, CeO₂, SnO₂, ZrO₂, BaCeO₃ und/oder BaTiO₃ als stabilisierender bzw. Flux Pinning bewirkende Zusätze in der erfindungsgemäßen Supraleitervormischung.

Sofern Y₂O₃ enthalten ist, ist ein Zusatz von 0,1 bis 50 Gew.-% dieser Verbindung, bezogen auf das als 100 Gew.-% gesetzte YBa₂Cu₃O₇₋ₓ-Pulver sehr vorteilhaft, sofern Y₂BaCuO₅ enthalten ist, sind 0,1 bis 50 Gew.-% vorteilhaft. Sofern PtO₂ enthalten ist, sind 0,5 bis 5 Gew.-% an Zusatz von PtO₂ vorteilhaft. Sofern Ag₂O enthalten ist, ist ein Zusatz von 1 bis 20 Gew.-% vorteilhaft. Sofern CeO₂, SnO₂, ZrO₂, BaCeO₃ und/oder BaTiO₃ enthalten ist, ist ein Gehalt von 0,1 bis 5 Gew.-% bevorzugt.

Eine erfindungsgemäße Supraleitervormischung mit besonders vorteilhaften Eigenschaften beim Schmelztexturieren enthält weniger als 0,05 Gew.-% Kohlenstoff, bezogen auf die YBa₂Cu₃O₇₋ₓ-Phase. Freies, nicht in der YBa₂Cu₃O₇₋ₓ-Phase gebundenes Kupferoxid ist vorzugsweise in einer Menge von weniger als 0,2 Gew.-%, enthalten.

Es hat sich als vorteilhaft erwiesen, wenn die Supraleitervormischung Partikel im Korngrößenbereich von oberhalb 30 bis hin zu 500 µm umfaßt. Besonders vorteilhaft ist es, wenn 40 bis 70 Gew.-% der Menge im angegebenen Korngrößenbereich liegen.

Gewünschtenfalls kann die erfindungsgemäße Supraleitervormischung gepreßt vorliegen, beispielsweise in Form von axial oder isostatisch verpreßten Formkörpern.

Im folgenden wird die Herstellung der erfindungsgemäßen Supraleitervormischung beschrieben. Hierzu vermischt man erfindungsgemäß ein YBa₂Cu₃O₇₋ₓ-Pulver, welches bezogen auf das YBa₂Cu₃O₇₋ₓ-Pulver weniger als 0,6 Gew.-% freies, nicht in der YBa₂Cu₃O₇₋ₓ-Phase gebundenes Kupferoxid und, bezogen auf das YBa₂Cu₃O₇₋ₓ-Pulver, weniger als 0,1 Gew.-% Kohlenstoff enthält, mit stabilisierenden und/oder ein "Flux Pinning" bewirkenden Zusätzen. Das Gemisch, d. h. die Vormischung, kann dann noch gewünschtenfalls verpreßt werden, beispielsweise axial oder isostatisch, unter Bildung von Formkörpern. Pulver mit bevorzugten Eigenschaften, die besonders gut geeigneten stabilisierenden bzw. Flux Pinning bewirkenden Zusätze und ihren bevorzugten Einsatzmengen sind vorstehend schon angegeben.

Im folgenden wird die Herstellung eines YBa₂Cu₃O₇₋ₓ-Pulvers angegeben, welches die für die Verwendung in der erfindungsgemäßen Supraleitervormischung benötigte Spezifikation bezüglich des freien Kupferoxidgehaltes und des Kohlenstoffgehaltes aufweist. Dieses besonders für die Anwendung in der erfindungsgemäßen Supraleitervormischung geeignete Pulver ist ebenfalls Gegenstand der Erfindung.

Dieses erfindungsgemäße, in der Supraleitervormischung besonders günstig einsetzbare YBa₂Cu₃O₇₋ₓ-Pulver stellt man her, indem man gepulverte Yttrium-, Barium- und Kupferverbindungen, welche Anionen umfassen, die Sauerstoff sowie gegebenenfalls Wasserstoff und/oder Kohlenstoff aufweisen und die in solchen Mengen eingesetzt werden, daß das Atomverhältnis von Yttrium, Barium und Kupfer sich im wesentlichen wie 1:2:3 verhält, miteinander vermischt,
a) man das feinzerteilte Ausgangsmaterial calciniert, indem man es auf eine Temperatur von 850 bis 920 °C in Sauerstoff enthaltender Atmosphäre aufheizt, bei dieser Temperatur hält und anschließend auf Raumtemperatur abkühlt und dann den angesinterten Pulverkörper fein zerkleinert,
b) man den Schritt a) ein- oder mehrmals wiederholt und nach der letzten Wiederholung beim Abkühlen im Temperaturbereich von 380 bis 420 °C eine Haltephase von bis zu 50 Stunden einlegt, bis die erhaltene Mischung voll oxidiert ist und in der erhaltenen Mischung der nachweisbare, nicht in der YBa₂Cu₃O₇₋ₓ-Phase gebundene Rest an Kupferoxid unterhalb 0,6 Gew.-% und weniger als 0,1 Gew.-% Kohlenstoff, bezogen auf das YBa₂Cu₃O₇₋ₓ-Pulver liegt,
c) man das in Stufe b) erhaltene Material zerkleinert.

Zweckmäßig verwendet man ein Pulver, von welchem mindestens 40 % des Materials im Korngrößenbereich von 30 bis 500 µm vorliegen. Insbesondere bevorzugt mischt man bei der Herstellung der erfindungsgemäßen Supraleitervormischung ein YBa₂Cu₃O₇₋ₓ-Pulver bei, bei welchem 40 bis 70 Gew.-% des Materials im Korngrößenbereich von 30 bis 500 µm vorliegen. Stellt man das Pulver nach der vorstehend beschriebenen Herstellungsweise her, ist es bevorzugt, nach der Haltephase das Material aufzumahlen und gegebenenfalls zu klassieren.

Das erfindungsgemäße YBa₂Cu₃O₇₋ₓ-Pulver wird vorteilhaft hergestellt, indem man Y₂O₃, CuO und Bariumhydroxid, wasserhaltiges Bariumhydroxid oder Bariumcarbonat einsetzt.

Die Calcination in der vorstehend beschriebenen Stufe a) kann man zweckmäßig derart durchführen, daß man das Ausgangsmaterial in lockerer oder vorverpreßter Form calciniert, indem es zunächst mit einer Geschwindigkeit von 100 bis 400 °C/h von Umgebungstemperatur auf eine Endtemperatur von 850 bis 920 °C an Luft aufgeheizt wird, für 100 bis 400 Stunden bei dieser Temperatur belassen wird und anschließend mit 100 bis 200 °C pro Stunde auf Umgebungstemperatur abgekühlt wird. Das erhaltene Material kann dann wie vorstehend schon erwähnt gewünschtenfalls aufgemahlt und gewünschtenfalls klassiert werden. Das YBa₂Cu₃O₇₋ₓ-Pulver wird zweckmäßig nach Beendigung der Haltephase mit dem oder den Zusätzen vermischt und gewünschtenfalls axial oder isostatisch in Formkörper verpreßt.

Die erfindungsgemäße Supraleitervormischung eignet sich hervorragend für die Herstellung schmelzprozessierter Hochtemperatursupraleiter mit hoher Levitationskraft. Die Formkörper, die mit der erfindungsgemäßen Vormischung hergestellt werden, sind sehr stabil; sie weisen (bei großer Probenanzahl) reproduzierbar hohe Levitationskräfte auf.

Das folgende Beispiel soll die Erfindung weiter erläutern, ohne sie in ihrem Umfang einzuschränken.

### Beispiel:

### a) Herstellung des YBa₂Cu₃O₇₋ₓ-Pulvers

Als Yttriumverbindung wurde handelsübliches Y₂O₃ mit Reinheitsgrad 99,99 %, als Kupferverbindung handelsübliches CuO mit Reinheitsgrad 99,999 % und als Bariumverbindung handelsübliches BaCO₃ mit Reinheitsgrad 99,4 % verwendet. Die Ausgangsmaterialien wurden entsprechend der gewünschten Zusammensetzung für eine herzustellende Menge von 500 g bemessen und homogen vermischt. Die Mischung wurde locker in Kawenit-Tiegel (Durchmesser 50 mm, Höhe 35 mm) verfüllt. Die Tiegel wurden in einem Labormuffelofen mit geringen Temperaturgradienten (ΔT < 1 K/cm) eingesetzt und mit 300 K/h aufgeheizt auf eine Endtemperatur von 905 °C. Bei dieser Temperatur wurde das Pulver 96 Stunden gehalten und danach mit 200 K/h auf Raumtemperatur abgekühlt. Der Pulverkuchen wurde gemörsert und gesiebt und dieses Granulat erneut in die Tiegel verfüllt. Das Granulat wurde bei gleicher Temperatur sowie bei gleichen Aufheiz- und Abkühlgeschwindigkeiten einem zweiten Temperzyklus über 72 Stunden, einem dritten Temperzyklus über 62 Stunden und einem vierten Temperzyklus über 70 Stunden unterworfen, wobei es nach jedem Temperzyklus gemörsert und gesiebt wurde. Im Anschluß an den letzten Zyklus wurde das Granulat bei 400 °C 1 Stunde gehalten, mit 200 K/h auf Raumtemperatur abgekühlt und zerkleinert. Alle Tempercyclen wurden in Luft ausgeführt. Das nachweisbare freie Kupferoxid im durchreagierten Pulver wurde mit Differenz-Thermoanalyse und Thermogravimetrie gemessen und liegt unter 0,2 Gew.-%. Der Kohlenstoffgehalt liegt nach chemischer Analyse unter 0,05 Gew.-%. Die weitgehende Umsetzung der Vormischung in die orthorhombische Phase war anhand der Dublett-Aufspaltung im Röntgenbeugungsspektrum nachweisbar.

### b) Kontrolle der Vormischung

Das Pulver wurde mit 9 Gew.-% Yttriumoxid und 1 Gew.-% Platinoxid vorvermischt. Die Vormischung wurde mit 3 MPa axial in Formkörper mit 35 mm Durchmesser und 20 mm Höhe verpreßt. Die Formkörper wurden mit 300 K/h auf 1190 °C aufgeheizt und 0,5 Stunden gehalten, danach mit 400 K/h auf 980 °C abgekühlt und von dieser Temperatur langsam mit 1 K/h auf 950 °C im Temperaturgradienten von 5 K/cm schmelzprozessiert. Die Abkühlung auf Raumtemperatur erfolgte mit 400 K/h. In einem separaten Temperprozeß zwischen 400 bis 600 °C über 144 Stunden wurde das Material in die orthorhombische Phase überführt. Im supraleitenden Zustand bei 77 Kelvin treten am Formkörper bei Annäherung eines SmCo-Permanentmagneten mit 25 mm Durchmesser und 10 mm Höhe im Abstand von 0,5 mm Levitations-Kräfte von 40 bis 60 N auf, entsprechend 30 bis 35 % der abstoßenden Kräfte für perfekte Abschirmung.

## Patentansprüche

1. Für die Schmelzprozessierung hergerichtete Supraleitervormischung, umfassend stabilisierende Zusätze und/oder Zusätze, die ein "Flux Pinning" bewirken sowie YBa₂Cu₃O₇₋ₓ-Pulver, welches bezogen auf das YBa₂Cu₃O₇₋ₓ-Pulver weniger als 0,6 Gew.-% freies, nicht in der YBa₂Cu₃O₇₋ₓ-Phase gebundenes Kupferoxid und, bezogen auf das YBa₂Cu₃O₇₋ₓ-Pulver, weniger als 0,1 Gew.-% Kohlenstoff enthält.

2. Supraleitervormischung nach Anspruch 1, dadurch gekennzeichnet, daß sie 0,1 bis 50 Gew.-% an stabilisierenden bzw. Flux-Pinning bewirkenden Zusätzen, bezogen auf das als 100 Gew.-% gesetzte YBa₂Cu₃O₇₋ₓ-Pulver enthält.

3. Supraleitervormischung gemäß Anspruch 1 oder 2, dadurch gekennzeichnet, daß sie 0 bis weniger als 0,2 Gew.-% freies nicht in der YBa₂Cu₃O₇₋ₓ-Phase gebundenes Kupferoxid enthält.

4. Supraleitervormischung nach Anspruch 1, 2 oder 3, dadurch gekennzeichnet, daß sie bezogen auf die YBa₂Cu₃O₇₋ₓ-Phase, weniger als 0,05 Gew.-% Kohlenstoff enthält.

5. Supraleitervormischung nach einem der Ansprüche 1 bis 4, dadurch gekennzeichnet, daß mindestens 40 % der Partikel des YBa₂Cu₃O₇₋ₓ-Pulvers im Korngrößenbereich von 30 bis 500 µm liegen.

6. Supraleitervormischung nach einem der vorhergehenden Ansprüche, dadurch gekennzeichnet, daß als stabilisierende bzw. "Flux Pinning" bewirkende Zusätze Yttriumoxid, Y₂BaCuO₅, Platindioxid, Ag₂O, CeO₂, SnO₂, ZrO₂, BaCeO₃ und/oder BaTiO₃ enthalten ist.

7. Supraleitervormischung nach Anspruch 6, dadurch gekennzeichnet, daß als stabilisierende bzw. "Flux Pinning" bewirkende Zusätze 0,1 bis 50 Gew.-% Y₂O₃, 0,1 bis 50 Gew.-% Y₂BaCuO₅, 0,5 bis 5 Gew.-% PtO₂, 1 bis 20 Gew.-% Ag₂O und/oder 0,1 bis 5 Gew.-% CeO₂, SnO₂, ZrO₂, BaCeO₃ und/oder BaTiO₃ enthalten sind, jeweils bezogen auf das als 100 Gew.-% gesetzte YBa₂Cu₃O₇₋ₓ₋-Pulver.

8. Verfahren zur Herstellung einer Supraleitervormischung gemäß einem der Ansprüche 1 bis 7, dadurch gekennzeichnet, daß man YBa₂Cu₃O₇₋ₓ-Pulver, welches bezogen auf das YBa₂Cu₃O₇₋ₓ-Pulver weniger als 0,6 Gew.-% freies, nicht in der YBa₂Cu₃O₇₋ₓ-Phase gebundenes Kupferoxid und, bezogen auf das YBa₂Cu₃O₇₋ₓ-Pulver, weniger als 0,1 Gew.-% Kohlenstoff enthält, mit Zusätzen, die stabilisieren und/oder ein "Flux Pinning" bewirken, vermischt und gegebenenfalls verpreßt.

9. Verfahren nach Anspruch 8, dadurch gekennzeichnet, daß man die Vormischung axial oder isostatisch in Formkörper verpreßt.

10. Verfahren nach Anspruch 7, 8 oder 9, dadurch gekennzeichnet, daß man YBa₂Cu₃O₇₋ₓ-Pulver einsetzt, welches hergestellt wurde, indem man gepulverte Yttrium-, Barium- und Kupferverbindungen, welche Anionen umfassen, die Sauerstoff sowie gegebenenfalls Wasserstoff und/oder Kohlenstoff aufweisen und die in solchen Mengen eingesetzt werden, daß das Atomverhältnis von Yttrium, Barium und Kupfer sich im wesentlichen wie 1:2:3 verhält, miteinander vermischt,
a) man das feinzerteilte Ausgangsmaterial calciniert, indem man es auf eine Temperatur von 850 bis 920 °C in Sauerstoff enthaltender Atmosphäre aufheizt, bei dieser Temperatur hält und anschließend auf Raumtemperatur abkühlt und dann den angesinterten Pulverkörper fein zerkleinert,
b) man den Schritt a) ein- oder mehrmals wiederholt und nach der letzten Wiederholung beim Abkühlen im Temperaturbereich von 380 bis 420 °C eine Haltephase von bis zu 50 Stunden einlegt, bis die erhaltene Mischung voll oxidiert ist und in der erhaltenen Mischung nachweisbare, nicht in der YBa₂Cu₃O₇₋ₓ-Phase gebundene Rest an Kupferoxid unterhalb 0,6 Gew.-% und weniger als 0,1 Gew.-% Kohlenstoff, bezogen auf das YBa₂Cu₃O₇₋ₓ-Pulver liegt,
c) man das in Stufe b) erhaltene Material zerkleinert.

11. Verfahren nach einem der Ansprüche 8 bis 10, dadurch gekennzeichnet, daß man nach der Haltephase das Material aufmahlt und gegebenenfalls klassiert, so daß mindestens 40 Gew.-% des gemahlenen Materials im Korngrößenbereich von 30 bis 500 µm vorliegen.

12. Verfahren nach einem der Ansprüche 8 bis 11, dadurch gekennzeichnet, daß man das Material nach Beendigung der Haltephase mit dem Zusatz oder den Zusätzen vermischt und das Gemisch axial oder isostatisch in Formkörper verpreßt.

13. Verfahren nach einem der Ansprüche 8 bis 12, dadurch gekennzeichnet, daß man das Ausgangsmaterial Yttrium in Form von Yttriumoxid (Y₂O₃), das Ausgangsmaterial Kupfer in Form von Kupferoxid (CuO) und das Ausgangsmaterial Barium in Form von Bariumhydroxid, wasserhaltigem Bariumhydroxid oder in Form von Bariumcarbonat einsetzt.

14. Verfahren nach einem der Ansprüche 8 bis 13, dadurch gekennzeichnet, daß man das Ausgangsmaterial in lockerer oder vorverpreßter Form calciniert, indem es zunächst mit einer Geschwindigkeit von 100 bis 400 °C/h von Umgebungstemperatur auf eine Endtemperatur von 850 bis 920 °C an Luft aufgeheizt wird, für 100 bis 400 Stunden bei dieser Temperatur belassen wird und anschließend mit 100 bis 200 °C pro Stunde auf Umgebungstemperatur abgekühlt wird.

15. Verfahren nach einem der Ansprüche 8 bis 14, dadurch gekennzeichnet, daß man das in Stufe b) erhaltene Material aufmahlt und klassiert, so daß 40 bis 70 Gew.-% des Materials im Korngrößenbereich von 30 bis 500 µm vorliegen.

16. YBa₂Cu₃O₇₋ₓ-Pulver, dadurch gekennzeichnet, daß es einen Kohlenstoffgehalt von weniger als 0,1 Gew.-% Kohlenstoff und weniger als 0,6 Gew.-% freies nicht in der YBa₂Cu₃O₇₋ₓ-Phase gebundenes Kupferoxid, jeweils bezogen auf das YBa₂Cu₃O₇₋ₓ-Pulver enthält.

## Claims

1. A superconductor premix prepared for melt processing, comprising stabilising additives and/or additives which effect "flux pinning" and also YBa₂Cu₃O₇₋ₓ powder, which relative to the YBa₂Cu₃O₇₋ₓ powder contains less than 0.6% by weight free copper oxide not bound in the YBa₂Cu₃O₇₋ₓ phase and, relative to the YBa₂Cu₃O₇₋ₓ powder, less than 0.1% by weight carbon.

2. A superconductor premix according to Claim 1, characterised in that it contains 0.1 to 50% by weight of stabilising or flux-pinning additives, relative to the YBa₂Cu₃O₇₋ₓ powder set as 100% by weight.

3. A superconductor premix according to Claim 1 or 2, characterised in that it contains 0 to less than 0.2% by weight free copper oxide not bound in the YBa₂Cu₃O₇₋ₓ phase.

4. A superconductor premix according to Claim 1, 2 or 3, characterised in that it contains less than 0.05% by weight carbon, relative to the YBa₂Cu₃O₇₋ₓ phase.

5. A superconductor premix according to one of Claims 1 to 4, characterised in that at least 40% of the particles of the YBa₂Cu₃O₇₋ₓ powder lie in the grain size range from 30 to 500 µm.

6. A superconductor premix according to one of the preceding claims, characterised in that it contains yttrium oxide, Y₂BaCuO₅, platinum dioxide, Ag₂O, CeO₂, SnO₂, ZrO₂, BaCeO₃ and/or BaTiO₃ as stabilising or flux-pinning additives.

7. A superconductor premix according to Claim 6, characterised in that it contains 0.1 to 50% by weight Y₂O₃, 0.1 to 50% by weight Y₂BaCuO₅, 0.5 to 5% by weight PtO₂, 1 to 20% by weight Ag₂O and/or 0.1 to 5% by weight CeO₂, SnO₂, ZrO₂, BaCeO₃ and/or BaTiO₃, each relative to the YBa₂Cu₃O₇₋ₓ powder set as 100% by weight, as stabilising or flux-pinning additives.

8. A process for the production of a superconductor premix according to one of Claims 1 to 7, characterised in that YBa₂Cu₃O₇₋ₓ powder, which, relative to the YBa₂Cu₃O₇₋ₓ powder, contains less than 0.6% by weight free copper oxide not bound in the YBa₂Cu₃O₇₋ₓ phase and, relative to the YBa₂Cu₃O₇₋ₓ powder, less than 0.1% by weight carbon, is mixed with additives which effect stabilisation and/or flux-pinning and the mixture is optionally pressed.

9. A process according to Claim 8, characterised in that the premix is pressed axially or isostatically into moulded bodies.

10. A process according to Claim 7, 8 or 9, characterised in that YBa₂Cu₃O₇₋ₓ powder is used which has been produced by mixing together powdered yttrium, barium and copper compounds which comprise anions which contain oxygen and also optionally hydrogen and/or carbon and which are used in such quantities that the atomic ratio of yttrium, barium and copper is essentially 1:2:3,
a) the finely-dispersed starting material is calcined by heating it to a temperature of 850 to 920°C in an oxygen-containing atmosphere, holding it at this temperature and then cooling it to room temperature and then finely grinding the sintered powdered body,
b) step a) is repeated one or more times and after the last repetition during cooling a holding phase of up to 50 hours is set in a temperature range from 380 to 420°C until the resulting mixture is completely oxidised and in the resulting mixture [the] remainder of copper oxide detectable and not bound in the YBa₂Cu₃O₇₋ₓ phase is less than 0.6% by weight and there is less than 0.1% by weight carbon, relative to the YBa₂Cu₃O₇₋ₓ powder,
c) the material obtained in stage b) is crushed.

11. A process according to one of Claims 8 to 10, characterised in that after the holding phase the material is ground and optionally classified, so that at least 40% by weight of the ground material is in the grain size range from 30 to 500 µm.

12. A process according to one of Claims 8 to 11, characterised in that once the holding phase has ended the material is mixed with the additive or the additives and the mixture is pressed axially or isostatically into moulded bodies.

13. A process according to one of Claims 8 to 12, characterised in that the starting material yttrium is used in the form of yttrium oxide (Y₂O₃), the starting material copper in the form of copper oxide (CuO) and the starting material barium in the form of barium hydroxide, hydrous barium hydroxide or in the form of barium carbonate.

14. A process according to one of Claims 8 to 13, characterised in that the starting material is calcined in loose or pre-pressed form by first heating it up at a rate of 100 to 400°C/h from ambient temperature to a final temperature of 850 to 920°C in air, then leaving it at this temperature for 100 to 400 hours and then cooling it to ambient temperature at 100 to 200°C per hour.

15. A process according to one of Claims 8 to 14, characterised in that the material obtained in stage b) is ground and classified, so that 40 to 70% by weight of the material is in the grain size range from 30 to 500 µm.

16. YBa₂Cu₃O₇₋ₓ powder, characterised in that it has a carbon content of less than 0.1% by weight carbon and less than 0.6% by weight free copper oxide not bound in the YBa₂Cu₃O₇₋ₓ phase, each relative to the YBa₂Cu₃O₇₋ₓ powder.

## Revendications

1. Prémélange supraconducteur apprêté pour subir un traitement par fusion, comprenant des additifs stabilisateurs et/ou des additifs qui engendrent un "pinning de flux", ainsi que de la poudre de YBa₂Cu₃O₇₋ₓ, qui contient moins de 0,6% en poids, rapporté à la poudre de YBa₂Cu₃O₇₋ₓ, d'oxyde de cuivre libre, non lié dans la phase de YBa₂Cu₃O₇₋ₓ, et moins de 0,1% en poids de carbone, rapporté à la poudre de YBa₂Cu₃O₇₋ₓ.

2. Prémélange supraconducteur selon la revendication 1, caractérisé en ce qu'il contient, rapportés à la poudre de YBa₂Cu₃O₇₋ₓ fixée comme représentant 100% en poids, de 0,1 à 50% en poids d'additifs stabilisateurs ou engendrant le pinning de flux.

3. Prémélange supraconducteur conforme à la revendication 1 ou 2, caractérisé en ce qu'il contient de 0 à moins de 0,2% en poids d'oxyde de cuivre libre, non lié dans la phase de YBa₂Cu₃O₇₋ₓ.

4. Prémélange supraconducteur selon la revendication 1, 2 ou 3, caractérisé en ce qu'il contient moins de 0,05% en poids de carbone, rapporté à la phase de YBa₂Cu₃O₇₋ₓ.

5. Prémélange supraconducteur selon l'une des revendications 1 à 4, caractérisé en ce qu'au moins 40% des particules de la poudre de YBa₂Cu₃O₇₋ₓ se situent dans la plage de granulométrie de 30 à 500 µm.

6. Prémélange supraconducteur selon l'une des revendications précédentes, caractérisé en ce qu'il y est contenu, en tant qu'additifs stabilisateurs ou engendrant le "pinning de flux", de l'oxyde d'yttrium, du Y₂BaCuO₅, du dioxyde de platine, du Ag₂O, du CeO₂, du SnO₂, du ZrO₂, du BaCeO₃ et/ou du BaTiO₃.

7. Prémélange supraconducteur selon la revendication 6, caractérisé en ce qu'il y est contenu, en tant qu'additifs stabilisateurs ou engendrant le "pinning de flux", de 0,1 à 50% en poids de Y₂O₃, de 0,1 à 50% en poids de Y₂BaCuO₅, de 0,5 à 5% en poids de PtO₂, de 1 à 20% en poids de Ag₂O et/ou de 0,1 à 5% en poids de CeO₂, de SnO₂, de ZrO₂, de BaCeO₃ et/ou de BaTiO₃, rapportés dans chaque cas à la poudre de YBa₂Cu₃O₇₋ₓ fixée comme représentant 100% en poids.

8. Procédé de préparation d'un prémélange supraconducteur conforme à l'une des revendications 1 à 7, caractérisé en ce qu'on mélange à des additifs, qui réalisent une stabilisation et/ou engendrent un "pinning de flux", et on comprime éventuellement, de la poudre de YBa₂Cu₃O₇₋ₓ qui contient moins de 0,6% en poids, rapporté à la poudre de YBa₂Cu₃O₇₋ₓ, d'oxyde de cuivre libre, non lié dans la phase de YBa₂Cu₃O₇₋ₓ, et moins de 0,1% en poids de carbone, rapporté à la poudre de YBa₂Cu₃O₇₋ₓ.

9. Procédé selon la revendication 8, caractérisé en ce que l'on comprime le prémélange axialement ou de façon isostatique en des corps façonnés.

10. Procédé selon la revendication 8 ou 9, caractérisé en ce que l'on utilise de la poudre de YBa₂Cu₃O₇₋ₓ que l'on a préparée en mélangeant entre eux des composés en poudre d'yttrium, de baryum et de cuivre, comprenant des anions, qui comportent de l'oxygène ainsi que, éventuellement, de l'hydrogène et/ou du carbone, et qui sont utilisés en des quantités telles, que le rapport atomique de l'yttrium, du baryum et du cuivre se présente sensiblement dans la proportion 1:2:3,
a) on calcine la matière de départ finement broyée, en la chauffant jusqu'à une température de 850 à 920°C dans une atmosphère contenant de l'oxygène, en la maintenant à cette température et en la refroidissant ensuite jusqu'à la température ambiante, puis en broyant finement le corps de poudre formé par frittage,
b) on répète une ou plusieurs fois l'étape a) et, après la dernière répétition, on incorpore, à un niveau de refroidissement situé dans la plage de températures de 380 à 420°C, une phase de maintien allant jusqu'à 50 heures, jusqu'à ce que le mélange obtenu soit complètement oxydé et qu'il y ait, dans le mélange obtenu, un résidu contrôlable inférieur à 0,6% en poids d'oxyde de cuivre, non lié dans la phase de YBa₂Cu₃O₇₋ₓ, et moins de 0,1% en poids de carbone, rapportés à la poudre de YBa₂Cu₃O₇₋ₓ,
c) on broie la matière obtenue à l'étape b).

11. Procédé selon l'une des revendications 8 à 10, caractérisé en ce qu'après la phase de maintien, on moût la matière et on la trie le cas échéant, afin qu'au moins 40% en poids de la matière moulue se trouvent dans la plage de granulométrie de 30 à 500 µm.

12. Procédé selon l'une des revendications 8 à 11, caractérisé en ce qu'à la fin de la phase de maintien, on mélange la matière à l'additif ou aux additifs et on comprime le mélange, axialement ou de façon isostatique, en des corps façonnés.

13. Procédé selon l'une des revendications 8 à 12, caractérisé en ce que l'on utilise la matière de départ constituée par l'yttrium sous forme d'oxyde d'yttrium (Y₂O₃), la matière de départ constituée par le cuivre, sous forme d'oxyde de cuivre (CuO), et la matière de départ constituée par le baryum, sous forme d'hydroxyde de baryum, d'hydroxyde de baryum aqueux ou sous forme de carbonate de baryum.

14. Procédé selon l'une des revendications 8 à 13, caractérisé en ce que l'on calcine la matière de départ sous une forme peu compacte ou pré-comprimée, en la chauffant tout d'abord à l'air, à une vitesse de 100 à 400°C/h, de la température de l'environnement jusqu'à une température finale de 850 à 920°C, en la laissant à cette température pendant 100 à 400 heures et en la refroidissant ensuite, sur 100 à 200°C par heure, jusqu'à la température de l'environnement.

15. Procédé selon l'une des revendications 8 à 14, caractérisé en ce que l'on moût la matière obtenue à l'étape b) et on la trie, afin que 40 à 70% en poids de la matière se trouvent dans la plage de granulométrie de 30 à 500 µm.

16. Poudre de YBa₂Cu₃O₇₋ₓ, caractérisée en ce qu'elle contient du carbone en une teneur de moins de 0,1% en poids de carbone et moins de 0,6% en poids d'oxyde de cuivre libre, non lié dans la phase de YBa₂Cu₃O₇₋ₓ, rapportés dans chaque cas à la poudre de YBa₂Cu₃O₇₋ₓ.
